# EUROPEAN PATENT SPECIFICATION

(11) **EP 1 389 753 B1**
(45) Date of publication and mention of the grant of the patent: **15.11.2006**
(21) Application number: 02028817.1
(22) Date of filing: 21.12.2002
(51) Int. Cl.: G06F 1/20

(54) **Apparatus for separating heat dissipation system from CPU**
Vorrichtung zur Trennung eines Wärmeableitungssystems von einer CPU
Dispositif pour séparer un système de dissipation de chaleur d'une unité centrale

(30) Priority: 08.08.2002 CN 02246868 U
(43) Date of publication of application: 18.02.2004
(73) Proprietor: Uniwill Computer Corporation, Chung Li City, Tao Yuan Hsien (TW)
(72) Inventor: Chen, Wei-Liang, Uniwill Computer Corporation, Chung Li City, Tao Yuan Hsien (TW)
(74) Representative: Flaccus, Rolf-Dieter

(56) References cited:
- US-A- 5 537 736
- US-A- 6 160 709

## Description

This application claims priority of China Patent Application Serial No.02246868.4 filed on August 8, 2002.

### Field of Invention

The present invention relates to an apparatus for assisting a separation operation, and more particularly, to an apparatus for conveniently separating a heat dissipation system from a central processing unit (CPU).

### Background of the Invention

For current computers, especially notebook computers, heat dissipation is always a difficult problem to be solved. Once the inner temperature of a computer goes too high, malfunction or unexpected crash may take place. To ensure that the inner temperature does not affect operations of the computer, a heat-dissipating apparatus, used to dissipate accumulated heat generated by a CPU, is indispensable.

Take a CPU in a notebook computer for example. When the CPU does not operate under a safe temperature, malfunction or unexpected crash may occur. Therefore, in general, a heat-dissipating apparatus or system in the notebook computer is contacted to the CPU to dissipate generated heat so as to lower the inner temperature of CPU. The heat-dissipating apparatus or system could be composed of a fan, a heat-dissipating block, a heat pipe, a heat sink, and so forth.

However, no matter what kind of heat dissipation system is adopted, it requires some particular heat-dissipating materials to contact the CPU for transmitting heat to the heat dissipation system. The main reason for further using the heat-dissipating material is that the surface of the heat dissipation system contacting the CPU is actually a coarse one manufactured by mechanical machines. Even implemented with the most precise manufacturing technique, the fineness of the surface has its limitation. That is to say, the surface of the heat dissipation system is not an ideal delicate surface, and neither is the surface of CPU die. Therefore, the heat-dissipating material is used to fill up gaps or holes between these two non-ideal surfaces so that the heat dissipation system can successfully absorb the heat generated by the CPU. The heat-dissipating material used to conduct heat can be thermal compound or thermal grease, which is a little bit glutinous without heat-dissipating ability.

Since the heat-dissipating material is a bit glutinous, it begins to melt and stick on the surface of the CPU when the heat-dissipating material is heated up. Therefore, the heat dissipation system and the CPU are bonded together tightly to transmit heat successfully. However, sometimes the bonding between them is so tight that users can hardly separate or detach them from each other.

Conventionally, users usually pull out the heat dissipation system and the CPU together from a case or a housing first, and then separate them by hands. However, pins of the CPU may be damaged or broken by careless users during the separation process. Moreover, the heat generated by the CPU or absorbed by the heat dissipation system will not allow operators in the assembly line to touch any of them by hands, not to mention to separate them.

Therefore, an apparatus for safely and conveniently separating the heat dissipation system from the CPU without causing any damage to the CPU is desired.

### Summary of the Invention

In view of the above issues, the present invention provides an apparatus as set out in claim 1.

Additional objects and advantages of the invention will be set forth in the following description and the accompanying drawings. The objects and advantages of the present invention may be realized and obtained by means of the instrumentalities and combinations of particulars pointed out in the appended claims.

### Brief Description of the Drawings

Fig. 1 shows a side view diagram of the apparatus of the present invention.

Fig. 2 shows an explosive view diagram of the apparatus of the present invention.

Fig. 3 shows a combinative diagram of the apparatus of the present invention.

Fig. 4 shows a schematic diagram of the apparatus of the present invention according to an embodiment.

Fig. 5A and Fig. 5B show schematic diagrams of the apparatus of the present invention according to an embodiment.

### Detailed Description of the Invention

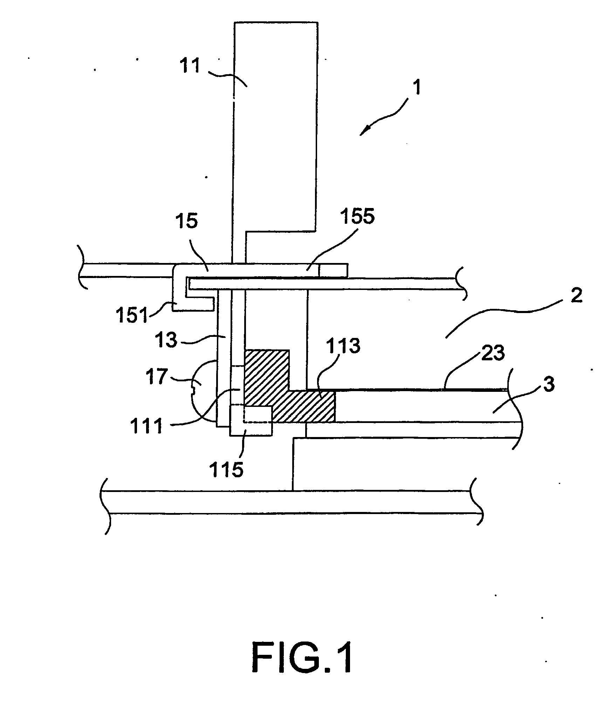

As shown in Fig. 1, the present invention provides an apparatus 1 for separating a first unit 2 from a second unit 3. The first unit 2 contacts the second unit 3 with a space 45 between an edge of the first unit 2 and an edge of the second unit 3. The space 45 is a gap or a room formed between the first unit 2 and the second unit 3 due to different sizes.

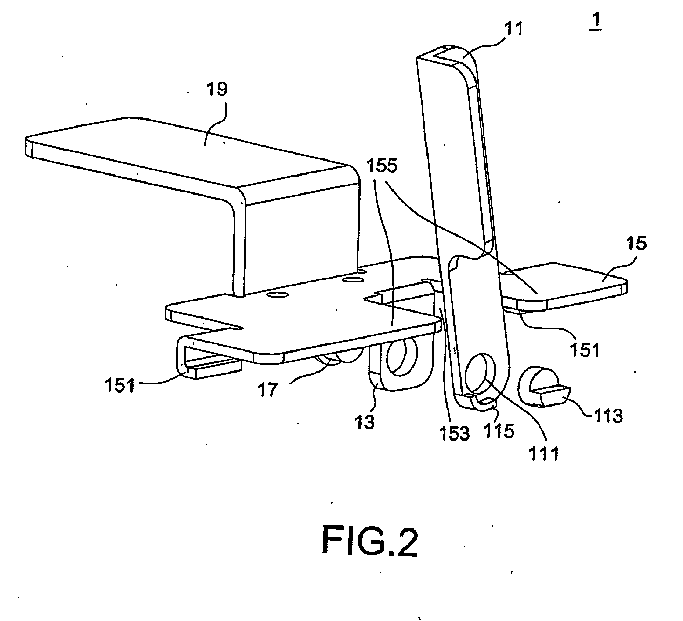

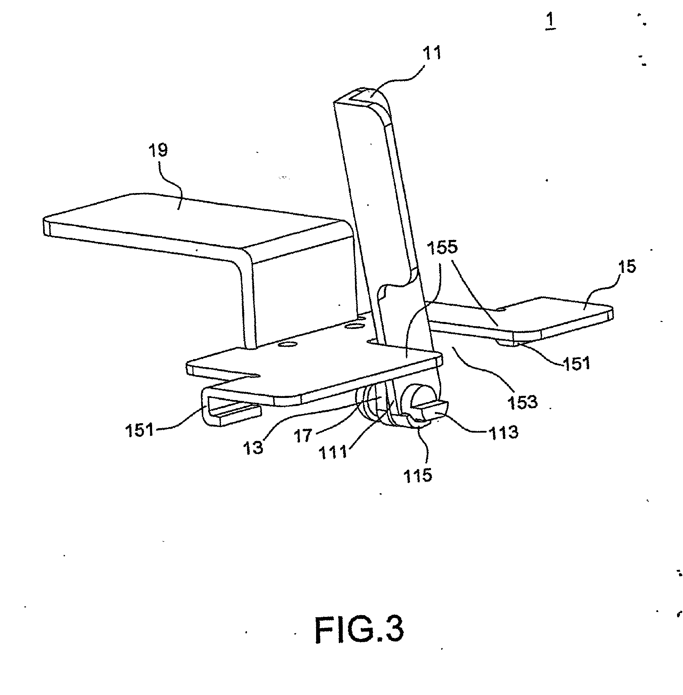

As shown in Fig. 1, Fig. 2, and Fig. 3, the apparatus 1 includes a control lever 11, a board 13, and a base 15. The control lever 11 has a pivot 111 and a protrusion 113. The protrusion 113 is disposed within the space 45. The size of the protrusion 113 just fits the space 45. The board 13 connecting to the pivot 111 prevents the control lever 11 from planar displacement. The base 15 has a first part bent downward to form the board 13 and an opening 153. The width of the opening 153 is used to limits the rotation range of the control lever 11.

Accordingly, the control lever 11 is kept from planar displacement by means of the board 13 and the opening 153 of the base 15 limits the rotation range of the control lever 11. When the control lever 11 rotates along the pivot 111, the protrusion 113 will move along with the control lever 11 and force the first unit 2 to separate from the second unit 3. Therefore, the first unit 2 is successfully separated from the second unit 3.

Furthermore, it is possible for the protrusion 113 to self-rotate or to get loose within the space 45 when the control lever 11 rotates. To avoid this problem, the apparatus 1 further includes a screw 17, and the control lever 11 further includes a limiter 115. The limiter 115 prevents the protrusion 113 from self-rotating when the control lever 11 rotates. The screw 17 connects the protrusion 113 and the pivot 111 to the board 13. By means of the screw 17, the protrusion 113 will become stable and move along with the control lever 11.

In the embodiment, the base 15 further includes at least a hook 151 for mounting the base 15 on a side of the first unit 2. The base 15 further includes a second part bent upward to form a handle 19 for facilitating users to retrieve the apparatus 1. Therefore, when the control lever 11 rotates along the pivot 111, the protrusion 113 forces the first unit 2 to separate from the second unit 3, and then users can hold the handle 19 to retrieve the first unit 2. In addition, the front side 155 of the base 15 is used as another pivot for further assisting the separation operation. By apparatus 1, the users can easily and successfully separate the first unit 2 from the second unit 3 and then retrieve the first unit 2 by holding the handle 19 without touching the first unit 2 or the second unit 3.

Accordingly; in assembly line of a manufacturing plant, there is no need for operators to touch those two units by their own hands while separating. They can accomplish the work safely and successfully by the apparatus 1 without worrying about heat or other substance generated during manufacturing or testing procedure.

The first unit 2 mentioned above can be a heat-dissipating block, a heat sink, or any other heat dissipation devices or systems. The second unit 3 mentioned above can be a central processing unit (CPU). Under this environment, in general, a heat-dissipating material 23, such as thermal compound or thermal grease, is spread between the contact of the first unit 2 and the second unit 3.

In the following description, an embodiment of a more complete heat dissipation system is described. However, the description below is nothing but an exemplary embodiment according to the present invention, which will not be a limitation to the invention.

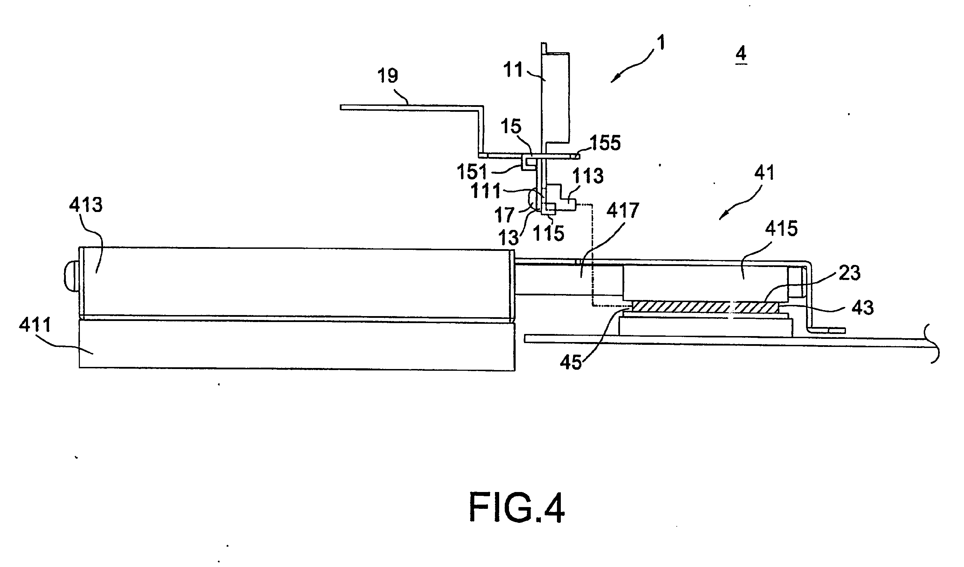

As shown in Fig. 4, the apparatus 1 of the present invention is used for separating a heat dissipation unit 41 of a heat dissipation system 4 from a central processing unit (CPU) 43. The heat dissipation unit 41 contacts the CPU 43 with a space 45 between an edge of the heat dissipation unit 41 and an edge of the CPU 43. The space 45 is a gap or a room formed between the heat dissipation unit 41 and the CPU 43 due to different sizes. In general, a heat-dissipating material 23, such as thermal compound or thermal grease, is spread between the contact of the heat dissipation unit 41 and the CPU 43.

The heat dissipation unit 41 includes a fan 411, a heat sink 413, a heat-dissipating block 415, and a heat pipe 417. The heat sink 413 is cooled by airflow generated by the fan 411. The heat-dissipating block 415 contacting with the CPU 43 absorbs heat generated by the CPU 43. The heat-dissipating block 415 then transmits the heat to the heat sink 413 via the heat pipe 417, and airflow dissipates the heat in the heat sink 413. Therefore, the heat generate by the CPU 43 is reduced by means of the heat dissipation unit 41 and makes the CPU 43 operate under a tolerable temperature.

As shown in Fig. 4, the apparatus 1 includes a control lever 11, a board 13, and a base 15. The control lever 11 has a pivot 111 and a protrusion 113. The protrusion 113 is disposed within the space 45 between an edge of the heat dissipation unit 41 and an edge of the CPU 43. The size of the protrusion 113 just fits the space 45. The board 13 connecting to the pivot 111 prevents the control lever 11 from planar displacement. The base 15 has a first part bent downward to form the board 13 and an opening 153. The width of the opening 153 limits the rotation range of the control lever 11.

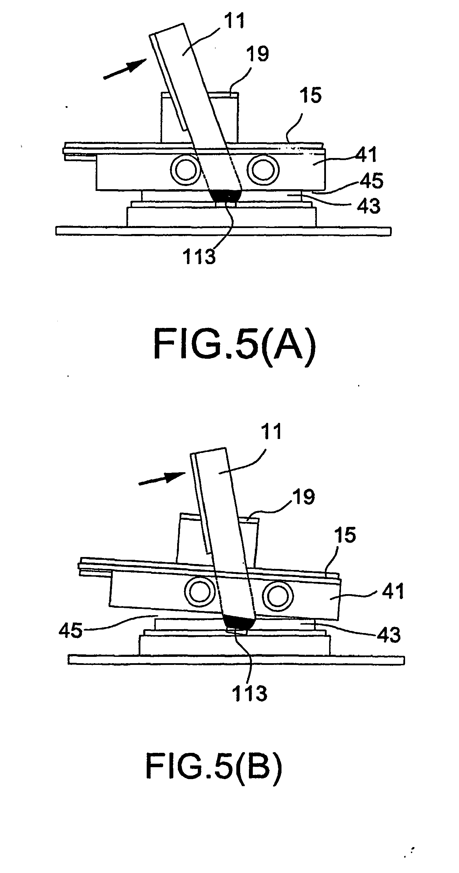

As shown in Fig. 5A, first of all, the protrusion 113 is disposed within the space 45 between an edge of the heat dissipation unit 41 and an edge of the CPU 43. As shown in Fig. 5B, the control lever 11 is kept from planar displacement by means of the board 13 and the width of the opening 153 of the base 15 limits the rotation range of the control lever 11. When the control lever 11 rotates along the pivot 111, the protrusion 113 will move along with the control lever 11 and force the heat dissipation unit 41 to separate from the CPU 43. Therefore, the heat dissipation unit 41 is successfully separated from the CPU 43. The objective to separate the heat dissipation unit 41 from the CPU 43 is then achieved.

Furthermore, it is possible for the protrusion 113 to self-rotate in the space 45 when the control lever 11 rotates. Therefore, the control lever 11 further includes a limiter 115. The apparatus 1 further includes a screw 17 (referring to Fig. 4). The limiter 115 prevents the protrusion 113 from self-rotating when the control lever 11 rotates. The screw 17 connects the protrusion 113 and the pivot 111 to the board 13. By means of the screw 17, the protrusion 113 will become stable and move along with the control lever 11.

In the embodiment, the base 15 further includes at least a hook 151 for mounting the base 15 on a side of the heat dissipation unit 41. The base 15 further includes a second part bent upward to form a handle 19 for facilitating users to take out the apparatus 1. Therefore, when the control lever 11 rotates along the pivot 111, the protrusion 113 forces the heat dissipation unit 41 to separate from the CPU 43, and then users can hold the handle 19 to retrieve the heat dissipation unit 41. In addition, the front side 155 of the base 15 is used as another pivot for further assisting the separation operation. By apparatus 1, users can easily and successfully separate the heat dissipation unit 41 from the CPU 43 and then retrieve the heat dissipation unit 41 by holding the handle 19 without touching any one of them.

From the described embodiment above, hands contact with high temperature units is not necessary. Therefore, the present invention solves the problem. Furthermore, when performing separation operation, the CPU 43 will not be pulled out along with the heat dissipation unit 41. Therefore, it is not possible to damage pins of the CPU 43 when performing separation operation.

Accordingly, the present invention provides an apparatus for safely separating a heat dissipation system from a central processing unit (CPU), without causing any damage to the CPU. Furthermore, the present invention can directly take the heat dissipation system away from the CPU after separation without worrying about the current temperature of the heat dissipation system. Therefore, the present invention saves much time in waiting for cooling of high temperature components. Moreover, without being touched by hands of operators in the manufacturing plant, the present invention prevents them from being burned or hurt for overheat, and therefore is more convenient and safer.

Furthermore, the above description may not give all unnecessary details, such as devices already mentioned or known by persons skilled in the art, which are not features of the present invention. However, with reference to the above description, persons skilled in the art are able to implement the apparatus of the present invention.

## Claims

1. An apparatus (1) for separating a heat dissipation unit (41) from a central processing unit (CPU) (43), said heat dissipation unit (41) contacting said CPU (43) with a space (45) between an edge of said heat dissipation unit (41) and an edge of said CPU (43), said apparatus (1) comprising:
- a control lever (11), having a pivot (111) and a protrusion (113), said protrusion (113) being disposed within said space (45);
- a board (13), connecting to said pivot (111), for preventing said control lever (11) from planar displacement; and
- a base (15), having a first part bent downward to form said board (13) and an opening (153), wherein width of said opening (153) limits the rotation range of said control lever (11);
wherein, when said control lever (11) rotates along said pivot (111), said protrusion (113) forces said heat dissipation unit (41) to separate from said CPU (43).

2. The apparatus (1) according to claim 1, wherein said base (15) further comprising:
- at least a hook (151) for mounting said base (15) on a side of said heat dissipation unit (41).

3. The apparatus (1) according to claim 1, wherein said control lever (11) further comprising:
- a limiter (115) for preventing said protrusion (113) from self-rotating when said control lever (11) rotates.

4. The apparatus (1) according to claim 1, wherein said apparatus (1) further comprising:
- a screw (17) for connecting said protrusion (113) and said pivot (111) to said board (13).

5. The apparatus (1) according to claim 1, wherein said base (15) further comprising a second part bent upward to form a handle (19).

6. The apparatus (1) according to claim 1, wherein said heat dissipation unit (41) is a heat-dissipating block (415).

7. The apparatus (1) according to claim 1, wherein said heat dissipation unit (41) is a heat sink (413).

8. The apparatus (1) according to claim 1, wherein said heat dissipation unit (41) comprising:
- a fan (411) for generating airflow;
- a heat sink (413) cooled by the airflow;
- a heat-dissipating block (415), contacting with said CPU (43), for absorbing heat generated by said CPU (43) second unit; and
- a heat pipe (417), connecting to said heat sink (413) and said heat-dissipating block (415) respectively, for transmitting the heat from said heat-dissipating block (415) to said heat sink (413).

## Patentansprüche

1. Vorrichtung (1) zur Trennung einer Wärmeableitungseinheit (41) von einem Hauptprozessor (CPU) (43), wobei sich die Wärmeableitungseinheit (41) mit der CPU (43) in Kontakt befindet und sich zwischen einer Kante der Wärmeableitungseinheit (41) und einer Kante der CPU (43) ein Freiraum (45) befindet und wobei die Vorrichtung (1) umfasst:
- einen Bedienhebel (11) mit einem Drehpunkt (111) und einem Vorsprung (113), wobei der Vorsprung (113) in dem Freiraum (45) angeordnet ist;
- eine Platte (13), die mit dem Drehpunkt (111) verbunden ist und dazu dient, eine ebene Verschiebung des Bedienhebels (11) zu verhindern; und
- eine Basis (15) mit einem ersten Teil, der abwärts gebogen ist und die Platte (13) bildet, und einer Öffnung (153), wobei der Rotationsbereich des Bedienhebels (11) durch die Breite der Öffnung (153) begrenzt wird;
bei welcher, bei Drehung des Bedienhebels (11) um den Drehpunkt (111), durch den Vorsprung (113) eine Trennung der Wärmeableitungseinheit (41) von der CPU (43) bewirkt ist.

2. Vorrichtung (1) nach Anspruch 1, bei der die Basis (15) weiterhin umfasst:
- wenigstens einen Haken (151) für die Montage der Basis (15) an einer Seite der Wärmeableitungseinheit (41).

3. Vorrichtung (1) nach Anspruch 1, bei welcher der Bedienhebel (11) weiterhin umfasst:
- einen Begrenzer (115), der dazu dient, eine Eigenrotation des Vorsprungs (113) während der Drehung des Bedienhebels (11) zu verhindern.

4. Vorrichtung (1) nach Anspruch 1, wobei die Vorrichtung (1) weiterhin umfasst:
- eine Schraube (17) zur Verbindung des Vorsprungs (113) und des Drehpunktes (111) mit der Platte (13).

5. Vorrichtung (1) nach Anspruch 1, bei welcher die Basis (15) weiterhin einen zweiten Teil umfasst, der aufwärts gebogen ist und einen Griff (19) bildet.

6. Vorrichtung (1) nach Anspruch 1, bei der die Wärmeableitungseinheit (41) ein Wärmeableitungsblock (415) ist.

7. Vorrichtung (1) nach Anspruch 1, bei der die Wärmeableitungseinheit (41) eine Wärmesenke (413) ist.

8. Vorrichtung (1) nach Anspruch 1, bei der die Wärmeableitungseinheit (41) umfasst:
- einen Lüfter (411) zur Erzeugung eines Luftstroms;
- eine durch den Luftstrom gekühlte Wärmesenke (413);
- einen Wärmeableitungsblock (415), der sich mit der CPU (43) in Kontakt befindet und dazu dient, Wärme, die von der CPU (43) erzeugt wird, zu absorbieren; und
- ein Wärmerohr (417), das mit der Wärmesenke (413) bzw. dem Wärmeableitungsblock (415) verbunden ist und dazu dient, die Wärme von dem Wärmeableitungsblock (415) zu der Wärmesenke (413) abzuleiten.

## Revendications

1. Dispositif (1) pour séparer une unité de dissipation de chaleur (41) d'une unité centrale (CPU) (43), ladite unité de dissipation de chaleur (41) étant en contact avec ladite unité centrale (43) avec un espace (45) entre un bord de ladite unité de dissipation de chaleur (41) et un bord de ladite unité centrale (43), ledit dispositif (1) comprenant :
- un levier de commande (11) pourvu d'un pivot (111) et d'une saillie (113), ladite saillie (113) étant située à l'intérieur dudit espace (45) ;
- une plaque (13) se reliant audit pivot (111) pour empêcher un déplacement planaire dudit levier de commande (11) ; et
- une base (15) pourvue d'une première partie pliée vers le bas pour former ladite plaque (13) et d'une ouverture (153), dans lequel la largeur de ladite ouverture (153) limite la plage de rotation dudit levier de commande (11) ;
dans lequel, lorsque ledit levier de commande (11) effectue une rotation le long dudit pivot (111), ladite saillie (113) oblige ladite unité de dissipation de chaleur (41) à se séparer de ladite unité centrale (43).

2. Dispositif (1) selon la revendication 1, dans lequel ladite base (15) comprend, en outre :
- au moins un crochet (151) pour monter ladite base (15) sur un côté de ladite unité de dissipation de chaleur (41).

3. Dispositif (1) selon la revendication 1, dans lequel ledit levier de commande (11) comprend, en outre :
- un limiteur (115) pour empêcher ladite saillie (113) d'effectuer elle-même une rotation lorsque ledit levier de commande (11) tourne.

4. Dispositif (1) selon la revendication 1, dans lequel ledit dispositif (1) comprend, en outre :
- une vis (17) pour relier ladite saillie (113) et ledit pivot (111) à ladite plaque (13).

5. Dispositif (1) selon la revendication 1, dans lequel ladite base (15) comprend, en outre, une deuxième partie pliée vers le haut pour former une poignée (19).

6. Dispositif (1) selon la revendication 1, dans lequel ladite unité de dissipation de chaleur (41) est un bloc dissipateur de chaleur (415).

7. Dispositif (1) selon la revendication 1, dans lequel ladite unité de dissipation de chaleur (41) est un dissipateur thermique (413).

8. Dispositif (1) selon la revendication 1, dans lequel ladite unité de dissipation de chaleur (41) comprend :
- un ventilateur (411) pour générer un courant d'air ;
- un dissipateur thermique (413) refroidi par le courant d'air ;
- un bloc dissipateur de chaleur (415) en contact avec ladite unité centrale (43) pour absorber la chaleur générée par ladite seconde unité CPU (43) ; et
- un caloduc (417) relié audit dissipateur thermique (413) et audit bloc dissipateur de chaleur (415), respectivement, pour transmettre la chaleur dudit bloc dissipateur de chaleur (415) vers ledit dissipateur thermique (413).
